# EUROPEAN PATENT APPLICATION

(11) **EP 1 741 534 A1**
(43) Date of publication of application: **10.01.2007**
(21) Application number: 05736662.7
(22) Date of filing: 27.04.2005
(51) Int. Cl.: B28D 5/00, B23K 26/40, C03B 33/09, H01L 21/301

(54) **METHOD FOR FORMING VERTICAL CRACK ON BRITTLE BOARD AND VERTICAL CRACK FORMING APPARATUS**

(30) Priority: 27.04.2004 JP 2004162570
(71) Applicant: Mitsuboshi Diamond Industrial Co., Ltd., Suita-city, Osaka Pref. 564-0044 (JP)
(72) Inventor: HASAKA, Noboru, MITSUBOSHI DIAMOND INDUSTR.CO. LTD, Suita-city, Osaka 5640044 (JP); KUMAGAI, Toru, MITSUBOSHI DIAMOND INDUSTR. CO. LTD, Suita-city, Osaka 5640044 (JP); YAMAMOTO, Koji, MITSUBOSHI DIAMOND INDUSTR.CO. LTD, Suita-city, Osaka 5640044 (JP)
(74) Representative: TBK-Patent
(86) International application number: PCT/JP2005/007993
(87) International publication number: WO 2005/102638

(57) **Abstract**

The forming of a heated spot (10) by using a laser beam irradiated to a brittle substrate along a predetermined scribing line (S) and the ejecting of a cooling medium, after interruption of irradiation of laser beam, to impinge on the spot to thereby form a cooled spot (20) constitute a unit operation to be repeated. The cooled spot overlapping the heated spot (10) that has a longitudinal center line (*b*) crossing the scribing line (S) at a right angle serves to restore thermal equilibrium in and around the spots while forming unit cracks (*n*) continued one from another to form a linear crack (E,U) perpendicular to the brittle substrate surface.

## Description

### FIELD OF THE INVENTION

The present invention relates to a method of and an apparatus for forming a perpendicular crack in a brittle substrate, and more particularly relates to such a method and such an apparatus that a laser beam is irradiated onto the brittle substrate along a scribing line so as to cause the laser beam to produce a heated spot on said brittle substrate, wherein a cooling medium will subsequently be ejected onto the heated spot in order to cool it down.

### BACKGROUND OF THE INVENTION

One of the methods known in the art and employed to form perpendicular cracks in brittle substrates such as semiconductor wafers, glass plates, ceramics plates or the like does use a laser beam that advances on and moves relative to each brittle substrate along a scribing line thereon. The laser beam will produce a heated spot on the brittle substrate, and this spot will immediately be followed by a cooled spot due to a cooling medium subsequently impinging on the brittle substrate at its portion adjacent to the heated spot.

When the laser beam is used in the prior art method, a compressive stress will be produced in and around the heated spot on one hand, with a tensile stress being generated in and around the cooled spot on the other hand. A differential stress thus appearing between the compressive and tensile stresses will function to make a perpendicular crack.

Usually, a trigger notch may be formed at first using an ordinary cutter or the like proper tool to scratch a side edge of the brittle substrate. The heated spot and cooled spot will start from such a notch so that the perpendicular crack reaches the back of said brittle substrate while extending along the surface thereof.

The Japanese Laying-Open Gazette No. 2003-321234 herein referred to as Patent Reference No. 1 discloses a method and an apparatus such that a laser source moves to irradiate a laser beam onto a glass plate's successive portions to be heated. A cooling medium will subsequently be ejected towards these portions so as to cut the glass plate. Velocity at which the laser source moves as well as the laser energy may be regulated depending on the varying position of the laser source, whereby the glass plate can be cut precisely and snugly.

The Japanese Laying-Open Gazette No. 2004-66745 as the Patent Reference No. 2 discloses another method of cutting a brittle substrate. A diffraction element diffracts a laser beam incident upon the brittle substrate such that a stripe-shaped beam has a longitudinal center line extending along a scribing line predetermined on the brittle substrate. A range over which thermal effect spreads itself across the scribing line is thus made narrower, thereby reducing any adverse influence upon an adjacent wiring or electronics devices.

If the laser beam continuously irradiated to the brittle substrate moves thereon as shown in Reference No. 1, then the cooling medium continuously sprayed towards the brittle substrate is prone to leave a deeper or back zone thereof not cooled enough.

If the stripe-shaped beam having a longitudinal center line along the scribing line is formed along the latter line as in Reference No. 2, then a gradient will take place between the compressive stress in a heated spot and the tensile stress in a cooled spot. The gradient observed in a direction aligned with the scribing line is greater than that observed in another direction intersecting this line. The stress gradient in the another line contributes to production of the perpendicular crack.

Consequently, such a stripe-shaped beam will need a higher energy to prolong the perpendicular crack along the predetermined scribing line, also tending to leave non-cooled a deeper or back zone of the brittle substrate.

The non-cooled zones will give rise to a residual stress so that since the crack thus formed has a depth considerably smaller than the substrate's thickness, a side edge face of the brittle substrate parts thus severed one from another will possibly be of a poor configuration quality.

### SUMMARY OF THE INVENTION

An object of the present invention made in view of these problems is therefore to provide a method of and an apparatus for forming a perpendicular crack in a brittle substrate such that its parts can be severed one from another to have their edges of an improved shape.

In order to achieve this object, the present invention provides from an aspect a novel method of forming a perpendicular crack in a brittle substrate, the method comprising the step of irradiating a laser beam onto the brittle substrate along a predetermined scribing line so as to cause the laser beam to produce at least one heated spot, and ejecting a cooling medium to impinge on the heated spot so as to form a cooled spot. Characteristically, the preceding step of forming the heated spot and the succeeding step of forming the cooled spot after interrupting the irradiation of laser beam onto the heated spot are combined with each other to constitute a unit operation enabling such an incremental formation of the perpendicular crack. The cooled spot superimposed on the previously heated spot is thus rendered effective to restore thermal equilibrium in and around the spots.

From another aspect, the present invention provides an apparatus for forming a perpendicular crack in a brittle substrate, the apparatus comprising an irradiation means for irradiating a laser beam onto the brittle substrate so as to provide a heated spot thereon, a transportation means for moving the laser beam relative to the brittle substrate and along a scribing line predetermined thereon, an ejection means for ejecting a cooling medium onto a brittle substrate portion where the heated spot has been formed, with this portion then forming a cooled spot, and a controller for controlling the irradiation, transportation and ejection means. The irradiation means is constructed such that the heated spot has a longitudinal center line intersecting the predetermined scribing line substantially at an angle of 90 degrees. The controller is constructed in such a fashion that the preceding step of forming the heated spot and the succeeding step of forming the cooled spot after interruption of the irradiation of laser beam onto the heated spot are combined with each other to constitute a unit operation. The unit operation is to be conducted at least one time so that the perpendicular crack of a unit length along the scribing line will penetrate the brittle substrate in a direction of its thickness and at one area of said brittle substrate. The controller will then give command signals to the irradiation, transportation and ejection means so as to repeat at least one time the unit operation at another area of said brittle substrate. A further crack thus formed and also having the unit length has to continue from the first mentioned crack along the scribing line. The cooled spot superimposed on the previously heated spot should be effective to restore thermal equilibrium in and around the spots.

According to the method of the invention, the unit operation is composed of the preceding step of forming the heated spot and the succeeding step of forming the cooled spot after interrupting the irradiation of laser beam onto the heated spot. The cooled spot superimposed on the previously heated spot is effective to restore thermal equilibrium in and around the spots. By virtue of this feature, settlement of thermal temporary imbalance will be effected every time when the unit operation is carried out to superimpose a new cooled spot on a previously formed heated spot. Any thermal stress will no longer be left in the brittle substrate once the perpendicular cracks are successively formed therein one after another in this manner, thus protecting it from curvature and torsion. Thus, a side edge face of each of brittle substrate parts severed one from another will have an excellent configuration quality.

In the method as summarized above, the heated spot may preferably have a longitudinal center line intersecting the predetermined scribing line substantially at an angle of 90 degrees. This feature is advantageous in that a stronger compressive stress is generated in the direction of such a longitudinal center line, so that an applied laser energy will effectively contribute to the smooth formation of a perpendicular crack along the predetermined scribing line, while diminishing a residual stress.

Also preferably to the method, a unit operation may be composed of the preceding step of forming the heated spot and the succeeding step of forming the cooled spot after interrupting the irradiation of laser beam onto the heated spot. The unit operation may be conducted at least one time so that the crack of a unit length along the scribing line will penetrate the brittle substrate in a direction of its thickness and at one area of the brittle substrate. The unit operation may be repeated at least one more time at another area of said brittle substrate and changing the location where heated spots are to be formed. As a result a further crack thus formed and also having the unit length may continue from the first mentioned crack along the scribing line. This mode of conducting the present method is advantageous in that energy loss can be avoided by adoption of a proper duration of each unit operation and by selecting the times of repetition of unit operations taking into account the thickness and material of the brittle substrate, as well as its area where the crack is to be formed.

In contrast with the prior art methods of continuously moving the position of laser beam, any single heated spot does not extend continuously herein, but discrete heated spots respectively have their longitudinal center line intersecting the scribing line at angle of 90 degrees. Laser energy applied to the brittle substrate will efficiently be utilized to the incremental formation of a perpendicular crack along the predetermined scribing line.

The unit operation for forming the perpendicular crack may be repeated some times without changing the position of heated and cooled spots at a start point of the predetermined scribing line. The start point is located near any side edge of the brittle substrate, and such repeated operations will engrave a trigger notch at the start point without using any cutter or the like tool. A continuous perpendicular crack will grow from the trigger notch in and along the surface of said brittle substrate, while penetrating the whole thickness thereof.

Each cooled spot may be formed to cover and cool an area larger than the corresponding heated spot previously formed, mainly due to heat of vaporization of the cooling medium. Thus, the heated spot will be cooled down quickly to ensure prompt recovery of thermal equilibrium.

An ink jet type ejection of the cooling liquid medium may be employed in order to shorten the periodical intervals at which the unit operations are repeated. The heated spots will be supplied with the thus jetted coolant at a rate enough to remove their heat.

Parameters for designing the heated spots may be radiation energy and duration of laser beams, shape and/or intervals of heated spots. Details of the unit operation may be optimized by adjusting these parameters in view of various conditions such as thickness and material of the brittle substrate as well as a location where the crack is formed.

Preferably, unit length 'L' of each perpendicular crack produced by one unit operation may be given in the direction of the scribing line, using an inequality: L/2 < D < L. This inequality, in which 'D' denotes a distance between the two adjacent unit cracks, means that the adjacent unit cracks will partially overlap one another or smoothly continue one from another without interruption.

The longitudinal center line of each heated spot does intersect the predetermined scribing line at an angle also in a region near or close to any end of the brittle substrate. Such an angle may be changed in order to select and regulate another angle at which the stress gradient will extend between the compressive stress generated in the heated spot and the tensile stress generated in the corresponding cooled spot. In one case, the perpendicular crack tending to become slanted or curved near the side edge of a brittle substrate can be amended to extend straight and in alignment with the predetermined scribing line.

In another case, the successive cracks may intentionally be made curved so as to form as a whole a curved continuous crack.

The predetermined scribing line may occasionally be located considerably near any side edge of the brittle substrate. In this case, the longitudinal center line of each heated spot may be swung a proper angle about a normal intersecting point where this center line will usually intersect the scribing line when repeating the unit operations. An inner sector of such a center line may thus be retracted in a direction opposite to the advancing direction of unit operations. By this way, the perpendicular crack tending to become curved near the side edge of a brittle substrate can be made straight in alignment with the predetermined scribing line.

The unit operation may be composed of the preceding step of simultaneously forming a number 'N' of heated spots and the succeeding step of simultaneously forming the same number 'N' of cooled spots after interrupting the irradiation of laser beam onto the heated spots. The unit operation enabling such an incremental formation of the perpendicular crack may be conducted at least one time so that a series of cracks each of a unit length are formed at once. This series of cracks will have an increased length that corresponds to the unit length multiplied by 'N' along the scribing line (in other words, the series being 'N' times as long as the unit crack). Also in this case, each crack included in such a series will penetrate the brittle substrate in a direction of its thickness and at one area of said brittle substrate. The unit operation may be repeated at least one more time at another area of said brittle substrate and changing the location where heated spots are to be formed this time. As a result of such a repetition, a further series of cracks thus formed and likewise having the increased length may smoothly continue from the first mentioned series of cracks along the scribing line.

This mode of conducting the present method is advantageous in that every unit operation produces 'N' heated spots at once so as to increase the length of every unit heated spot and to thereby reduce the number of unit operations to be repeated for different areas of the brittle substrate, thus accelerating the formation of a complete perpendicular crack.

A further inequality: 0 < *a* < 4*t* in which *a* denotes the major axis of each heated spot on the substrate, with *t* indicating the thickness thereof, may apply to the process for forming the heated spots. By means of this inequality, each heated spot may be formed with an energy whose level will depend on the thickness.

A still further inequality: 0 < C < *a*/2 in which *a* denotes the major axis of each heated spot on the brittle substrate, with 'C' indicating a diameter of each cooled spot regarded as a circle, may likewise apply to the process for forming the cooled spots by ejection of the cooling medium. By virtue of this feature, a thermal and temporary imbalance will be canceled for each spot every time when the unit operation is carried out, lowering the intensity of residual stress tending to be left after the unit operation.

As summarized above, the controller installed in the present apparatus is constructed such that a unit operation is composed of the preceding step of forming the heated spot and the succeeding step of forming the cooled spot after interrupting the irradiation of laser beam onto the heated spot. The unit operation may be performed at least one time so that the perpendicular crack of a unit length along the scribing line will penetrate the brittle substrate in a direction of its thickness and at one area of said brittle substrate. The controller will then give command signals to all the relevant means so as to repeat at least one time the unit operation at another area of said brittle substrate. A further crack thus formed to have the unit length will continue from the first mentioned crack along the scribing line. The cooled spot overlapping the previously heated spot is effective to restore thermal equilibrium in and around the spots.

Thus, a thermal imbalance will be canceled every time when the unit operation for forming the perpendicular crack is carried out, reducing the residual thermal stress. Consequently, the times of unit operations can be adjusted properly in view of the thickness and material of the brittle substrate, the location where the crack is formed, and the like parameters.

In contrast with the prior art methods, neither the laser beam nor the spot heated therewith is any longer moved in a continuous manner, ensuring that the heated spot has its major axis intersecting the predetermined scribing line at a right angle. Laser energy applied to that spot is fully utilized to smoothly form the perpendicular crack along the scribing line.

The controller may give command signals to the relevant means to repeat several times the unit operation for forming the perpendicular crack, without changing the position of heated and cooled spots at a start point of the predetermined scribing line. Any cutter or the like tool is not necessary to engrave a trigger notch near a side edge of the brittle substrate. A continuous perpendicular crack will start from the notch and grow in and along the surface of said brittle substrate, while completely penetrating the whole thickness thereof.

An ink jet type ejection of the cooling medium may be adopted to shorten the period of repeated unit operations. Each of heated spots will receive the jetted coolant at a rate enough to remove their heat.

The ejection means may be accompanied by a supplementary cooling means so that after the jetted coolant has formed each cooled spot, the cooling means will cover an area larger than the heated spot. Thus, the heated spot is allowed to quickly cool down for prompt recovery of thermal equilibrium.

The controller may also give command signals to each relevant means to form the heated spots taking into account the parameters such as radiation energy and duration of laser beams, shape and/or intervals of those spots. Thus, the unit operation is adapted for various conditions such as thickness and material of the brittle substrate as well as a location thereof where the crack is formed.

The controller may give further command signals to the transportation means so that unit length 'L' of the cracks and a distance 'D' between the two adjacent unit cracks do satisfy an inequality: L/2 < D < L. Consequently, the adjacent unit cracks will overlap one another or smoothly continue one from another without any gap left between them.

The controller may also give command signals to the irradiation means at any location near any end of the brittle substrate, so as to change an angle at which the major axis of each heated spot intersects the predetermined scribing line. It will thus be enabled to select and regulate another angle at which stress gradient extends between the compressive stress in a heated spot and the tensile stress in a corresponding cooled spot. The perpendicular crack prone to curve near the side edge of a brittle substrate can now be straightened and aligned with the predetermined scribing line.

As noted above, the predetermined scribing line may occasionally be located considerably near any side edge of the brittle substrate. In this case, the controller may function so that the longitudinal center line of each heated spot is swung a proper angle about a normal intersecting point where this center line will usually intersect the scribing line when repeating the unit operations. An inner sector of such a center line may thus be retracted in a direction opposite to the advancing direction of unit operations. By this way, the perpendicular crack tending to become curved near the side edge of a brittle substrate can be made straight in alignment with the predetermined scribing line.

Also preferably, the controller may give command signals to all the relevant controlling means to perform a unit operation that will be composed of the preceding step of simultaneously forming 'N' heated spots and the succeeding step of simultaneously forming 'N' cooled spots after interrupting the irradiation of laser beam onto the heated spots. The unit operation may be conducted at least one time so that a series of cracks each of a unit length are formed at once. This series of cracks will have an increased length that corresponds to the unit length multiplied by 'N' along the scribing line. Also in this case, each crack included in such a series will penetrate the brittle substrate in a direction of its thickness and at one area of said brittle substrate. The unit operation will be repeated at least one more time at another area of said brittle substrate and changing the location where the heated spots are to be formed this time.

As a result, a further series of cracks thus formed and likewise having the increased length may smoothly continue from the first mentioned series of cracks along the scribing line. Every unit operation produces 'N' heated spots at once so as to reduce the number of displacements which the laser beam has to make for different areas of a brittle substrate, thus accelerating the formation of a complete perpendicular crack.

Further, the controller may command the irradiation means to operate satisfying another inequality: 0 < *a* < 4*t* in which *a* denotes the major axis of each heated spot on the brittle substrate, with t indicating the thickness thereof. By means of this inequality applied to the process for forming the heated spots, each of them is formed with an energy matching the thickness of brittle substrate.

Moreover, the controller may command the ejection means to perform under the condition that is defined with still another inequality: 0 < C < *a*/2 in which *a* denotes the major axis of each heated spot on the brittle substrate, with 'C' indicating a diameter of each cooled spot regarded as a circle. The step of forming the cooled spots by ejection of the cooling medium is thus carried out such that a thermal imbalance will be canceled every time when the unit operation is carried out, without leaving any noticeable intensity of thermal stress after the unit operation.

### BRIEF DESCRIPTION OF THE DRAWINGS

Fig. 1 is a scheme showing a process which the present invention pro-vides to form a continuous perpendicular crack along a scribing line that is predetermined on a brittle substrate;
Fig. 2 also is a scheme showing a positional relationship between the spots onto which a laser beam is irradiated;
Fig. 3 is a schematic perspective view of an apparatus for forming such a perpendicular crack;
Fig. 4 illustrates a driven head installed in the apparatus;
Fig. 5 shows a mode of the process that is employed when the pre-deterrnined scribing line is located near either side edge of the brittle substrate; and
Fig. 6 shows is a curved perpendicular crack that may be formed in another mode of the process.

### THE PREFERRED EMBODIMENTS

Now some embodiments of the present invention will be described referring to the accompanying drawings.

A brittle substrate treated with in this invention is not delimited to any particular kind but may vary as to its configuration, material, usage and/or dimension. The brittle substrate may be a single-layer plate, or alternatively be a composite plate composed of strata bonded one to another. A thin semiconductor membrane or some semiconductor terminals may be attached to the surface of such a brittle substrate, or be embedded therein.

The material of the brittle substrate may be a glass, a sintered ceramics article, a silicon single crystal, sapphire or the like. Such a brittle substrate may be used as a panel for any flat panel displays (FPD) such as liquid crystal displays, plasma displays, organic EL displays or the like, or used as a ceramics substrate for ceramics condensers, or a wafer substrate for semiconductor chips or the like,

Some examples of the apparatus provided herein to form a perpendicular crack will now be described, but they are not meant to restrict the scope of the present invention.

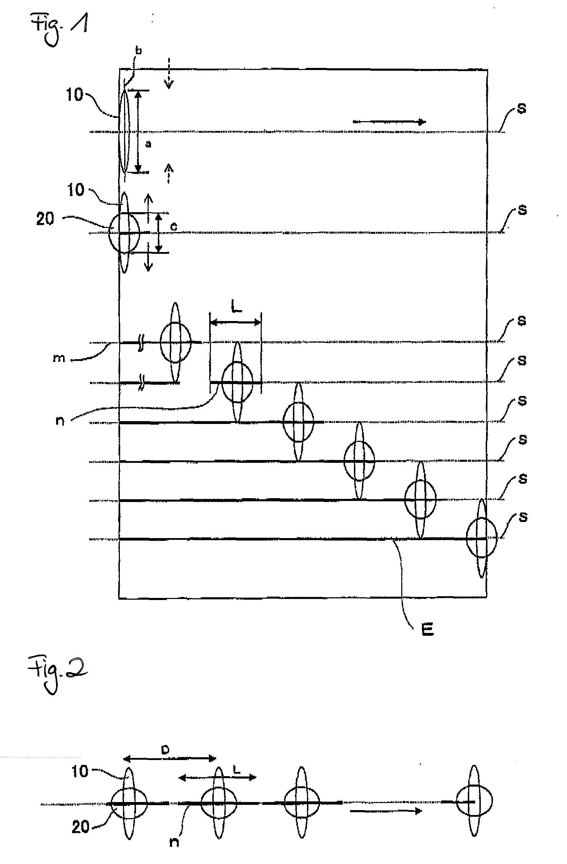

Reference is made now to Figs. 1 to 6 that illustrate the embodiments and examples of the invention.

The invention provides a method of and an apparatus for the incremental formation of a continuous perpendicular crack along a predetermined scribing line. The present method does include the step of irradiating a laser beam onto a brittle substrate to produce a heated spot as the part of a heated region, during the intermittent movement of a laser source along the scribing line and relative to the brittle substrate. At the subsequent step, a cooling medium will be jetted onto the heated region so as to produce there a cooled spot. These steps constitute herein a principal process.

This process may be composed as a unit operation for forming the perpendicular crack, and the unit operation may consist of the preliminary step of forming one heated spot and the subsequent step of forming one cooled spot after interruption of the irradiation of laser beam.

The 'perpendicular ' crack is meant herein to denote a crack extending perpendicularly to the surface of brittle substrate, and it may be an invisible blind crack, or a possibly visible one that is either complete or incomplete to divide the brittle substrate into parts.

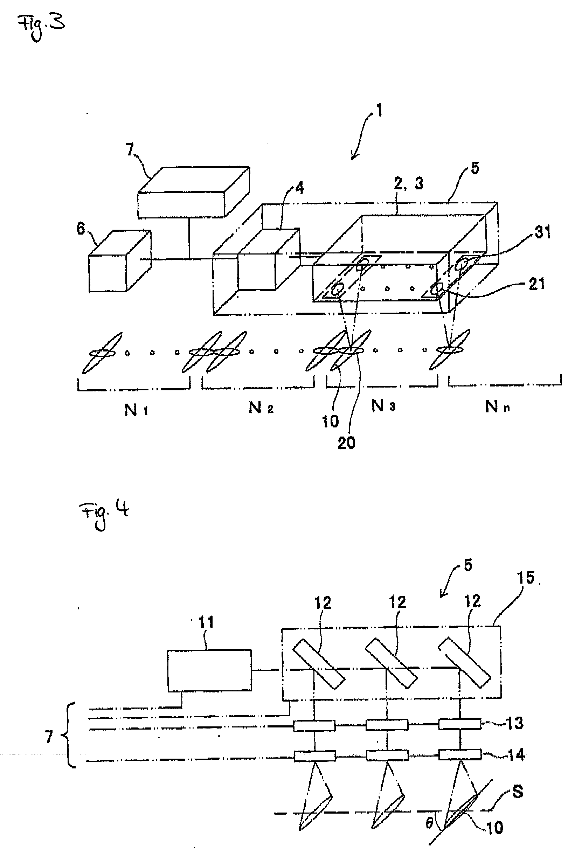

Figs. 1 and 2 show a process for forming a continuous perpendicular crack along a predetermined scribing line.

As seen from Fig.1, each of the heated spots 10 formed using the laser beam does generally extend along a longitudinal center line *b* to have a major axis *a*. This center line *b* extends in a direction intersecting the predetermined scribing line 'S' at a right angle.

Such a shape of each heated spot 10 will generate a compressive stress (schematically indicated by the broken arrows) that is much stronger in the direction of scribing line 'S' than in another direction perpendicular thereto.

In order to decrease the times of unit operations repeated at one and the same region, each spot 10 will be formed using the laser beam at a minimum energy level that is necessary and sufficient to produce the perpendicular crack.

Subsequent to this step, a cooling medium will be ejected to the already heated spot 10 and vicinity thereof to form a cooled spot 20, thereby quenching the former spot 10. Usually, the cooled spot 20 having a diameter 'C' is disposed on the scribing line 'S' and generally middle region of the longitudinal center line *b* of the heated spot.

The size of cooled spot 20 as well as quantity of the cooling medium used are designed such that thermal equilibrium will be recovered in and around the heated spot 10. Any thermal imbalance is thus canceled whenever the unit operation of forming is finished for and at the spot, lest any residual stress should be left. Since a minimum but sufficient amount of cooling medium is ejected onto the heated spot 10 and vicinity thereof, the cooled spot 20 will cool down the heated spot 10, without unnecessarily wasting the cooling medium.

As will be seen in Fig. 1, the forming of the cooled spot 20 causes generation of a tensile stress (schematically indicated by solid arrows) that is strongest in a direction intersecting the scribing line 'S' at a right angle. Consequently, a differential stress appears in this direction so that a perpendicular crack of a unit length 'L' is produced in alignment with the scribing line 'S'. This perpendicular crack having the unit length 'L' corresponding to each cooled spot 20 will be referred to hereinafter as a unit crack *n*.

For the purpose of producing such a unit crack *n* along the scribing line 'S', an intensive differential stress should be generated across the scribing line 'S'. This is because any differential stress aligned with this line 'S' will not contribute to but will rather hinder any crack from extending along this line.

In the event that as in the prior art systems any heated spots each having a longitudinal center line along the scribing line 'S' are involved, then an extraordinarily intensive differential stress would be required to overwhelm a differential stress naturally appearing along said line 'S'.

In contrast, each heated spot 10 produced in the invention has its longitudinal center line *b* across the predetermined scribing line 'S', whereby a laser beam irradiated at a lowest possible energy level and for a shortest possible time will suffice well to produce the unit crack *n*.

In the invention, every crack forming unit operation will be carried out in such a manner that a heated spot 10 is produced by irradiation of a laser beam, while keeping it stationary.

If contrarily the laser beam is irradiated continuously to a heated spot 10 while moving along the scribing line 'S', then this spot 10 will assume a stripe-like shape elongated in alignment with this line 'S'. In this case, such a hypothetical heated spot 10 would fail to afford the advantages of a heated spot 10 proposed herein to have its longitudinal center line *b* across the said scribing line 'S'.

After the formation of cooled spot 20 is finished, the next area to be irradiated with the laser beam will be determined.

Fig. 2 shows an array of those areas that are successively irradiated with the laser beam.

Preferably, a distance 'D' defined between the two adjacent perpendicular unit cracks *n* each of a unit length 'L' does satisfy an inequality L/2 < D < L as seen in Fig. 2.

Any noticeable clearance does neither intervene between the two adjacent unit cracks *n*, nor they do overlap one another by half a unit length or more.

Once the next area to be irradiated with the laser beam is determined as mentioned above, the next unit operation will commence. A period of unit operations, that is a time interval between the start of preceding unit operation and that of succeeding one, may preferably be regulated within a range from 0.01 *sec* to 0.1 *sec.*

Repetition of such unit operations will produce a perpendicular crack 'E' composed of successive unit cracks *n* that continue one from another without interruption, as shown in Fig. 1.

According to the present invention, if a start point of predetermined scribing line 'S' is located at *m* adjacent to the side edge of the brittle substrate, then the unit operations will be repeated a few or several times without changing the position of each spot. Thus, a trigger notch will be provided near the said side edge so that the perpendicular crack 'E' penetrating the brittle substrate is allowed to grow towards a central or middle region of said brittle substrate.

Such a repetition of unit operations at a fixed position for irradiation of laser beam is not only done at the location *m*, but also may be done for any desired portion of the brittle substrate. The number of repeated unit operations will be selected not only depending on the material and/or thickness of the brittle substrate but also taking into account the output energy level of laser beam source.

Preferably, each heated spot 10 may satisfy an inequality: 0 < *a* < 4*t* in which *a* denotes the length of longitudinal center line (i.e., major axis) of the spot on brittle substrate, with *t* denoting the thickness thereof. More-over, each cooled spot 20 may satisfy another inequality: 0 < C < *a*/2 in which 'C' denotes an apparent diameter of the spot 20 if it is regarded as a circle. These two inequalities will derive a further relationship 0 < C < 2*t* between the parameters *t* and 'C'.

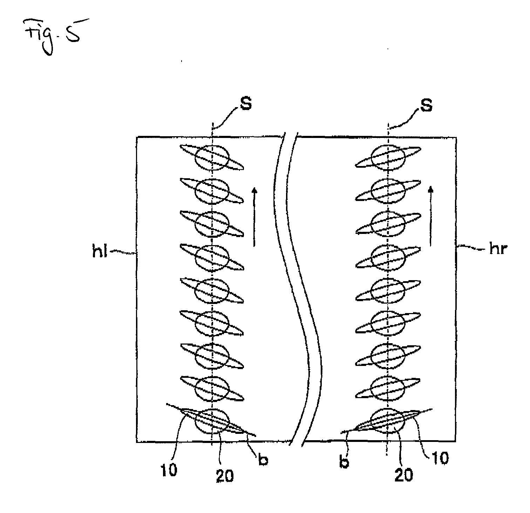

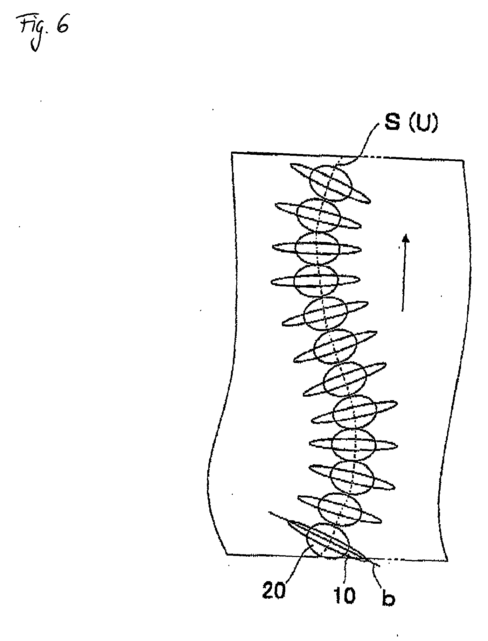

Figs. 3 and 4 show an example of the apparatus provided herein to form a perpendicular crack.

The structure is illustrated schematically in Fig. 3.

As shown in Fig. 3, the apparatus 1 for forming the perpendicular crack comprises a laser beam irradiation means 2, a cooling medium ejection means 3, and a driven head 5 having a drive unit 4 for the preceding two means. The apparatus further comprises a laser beam transportation means 6 for shifting the driven head 5 relative to the brittle substrate, and a controller 7 for controlling all the means and head.

Fig. 4 is a scheme of the structure of driven head 5 shown in Fig. 3.

As seen in Fig. 4, the driven head 5 comprises a laser transmitter 11, and a plurality of beam splitters 12 designed to divide the laser beam from the transmitter 11 into reflected rays and transmitted rays at a given ratio of the former to the latter. The driven head 5 further comprises shutters 13 adapted to transmit the reflected rays from the splitters, respectively at given timings and for given periods. Each of optical devices 14 also incorporated in the driven head 5 will regulate the laser beam from the corresponding shutter 13 so as to make it coincide with the desired shape of each heated spot 10. The head 5 still further comprises a mirror moving mechanism 15 for regulating the function of each beam splitter 12.

The laser transmitter 11 may for example be a CO₂ gas laser generating a laser beam with a pulse frequency adjustable within a range from 0 kHz to 200 kHz to have a pulse width that is adjustable within a range from 0.01 *sec* to 0.1 *sec*, at an output energy level adjustable within a range from 3 W to 20 W. In this invention, pulse widths usually relevant to radio frequency are designed to continue one from another.

Each optical device 14 is capable of regulating the laser beam rays to be of any desired configuration and dimension of the heated spots 10, along the predetermined scribing line 'S' on the brittle substrate. In detail, the ratio of major axis to minor axis of each heated spot 10, a maximum major axis, and an angle *θ* at which the major axis intersects the scribing line 'S' may be adjusted using such an optical device 14.

The mirror moving mechanism 15 will enable the change in interval between the adjacent beam splitters 12, and/or the change in posture angle of each beam splitter, so as to select a distance by which the adjacent unit cracks *n* overlap one another.

As shown in Fig. 3, the laser beam irradiation means 2 comprises a plurality of laser emission nozzles 21 that emit laser beams through the optical devices 14 shown in Fig. 4 and onto the brittle substrate. The cooling medium ejection means 3 comprises a plurality of jet nozzles 31 for jetting drips of the cooling medium. The former and latter nozzles 21 and 31 are respectively combined such that 'N' units 51 each composed of one nozzle 21 and the other nozzle 31 adjacent thereto are arranged in a row within the driven head 5.

The laser beam transportation means 6 can move the head 5 intermittently at any desired period, relative to three directions including the scribing line. The cooling medium jet nozzles 31 may be of the ink jet type widely adopted in the printers or the like, and the cooling medium may for example be water, ammonia or liquid nitrogen. The cooling medium may alternatively be any mixture of one of these liquids with any gas such as helium, air or carbon dioxide.

The controller 7 commands the laser beam irradiation means 2 through the drive unit 4 so as to regulate the formation of 'N' heated spots 10. In detail, laser beam will be emitted spontaneously from the 'N' laser emission nozzles 21 to form all the heated spots 10 at the same time.

Subsequently, the controller 7 will command the cooling medium ejection means 3 to jet the medium simultaneously to and around all the heated spots 10. The cooling medium jetted from the nozzles 31 will thus form cooled spots 20 superimposed on or partially covering the respective heated spots.

A difference appearing between the compressive stress generated in each heated spot 10 and the tensile stress generated in the corresponding cooled spot 20 will produce each of the perpendicular unit cracks *n*, the number thereof being 'N'. The adjacent unit cracks *n* that are produced in sequence will grow to adjoin one another in the course of time but before long.

Each cooled spot 20 spreads wider than the corresponding heated spot 10 so that heat of vaporization removed from the latter spot will cool it down rapidly, thereby recovering thermal equilibrium in a short time.

Since 'N' spots are produced at once by every unit operation whose period is 'T', an average or overall period of forming each spot will be T/N in this apparatus 1 for forming perpendicular cracks.

Subsequent to the ink jet type ejection of the cooling medium, a supplementary cooling means such as air-cooling may additionally be applied to those cooled spots.

The perpendicular crack forming apparatus 1 may repeat the unit operation for simultaneously forming unit cracks *n,* the number thereof being 'N' and each fully penetrating the thickness of the brittle substrate. In this case, the 'N' unit cracks *n* will be connected one to another to provide along the scribing line 'S' a first segment of cracks, whose length is LxN (shown as N₁ in Fig. 3). After moving the driven head 5 one stroke ahead, a second segment of cracks whose length also is LxN (shown as N₂ in Fig. 3) will be produced by forming the similar spots on another area of this brittle substrate. Such a unit operation will be repeated until the number of segments becomes Nₙ in an example shown in Fig. 3.

Every stroke of the apparatus produces several ('N') heated spots at once along the scribing line on the brittle substrate. As compared with employing one emission nozzle 21 and one jet nozzle 31, this mode will reduce the number of strokes for processing all the required areas, thus remarkably accelerating the forming of perpendicular cracks 'E'.

Amendment or adjusting of the operation may be done as follows, when the predetermined scribing line 'S' is located near and in parallel with any side edge of the brittle substrate,

Fig. 5 illustrates the performance of the apparatus in this case.

If the scribing line 'S' is remote from such an edge, then temperature distribution will sufficiently be uniform across such a line.

However, temperature distribution will become considerably asymmetric with respect to the scribing line 'S', if it is located closer to the side edge. Perpendicular unit cracks *n* produced in this case will have their ends offset towards either side away from the predetermined line 'S'.

The controller 7 built in the present apparatus will therefore modify the unit operation in the event that the scribing line 'S' would be located near and in parallel with a side edge *h*. In detail, one of the sectors of each longitudinal center line *b* of each heated spot 10 is located inwardly away from the edge *h*, with the other sector facing it. The inward sector will be swung backwards (in the sense of advancement direction of apparatus) an angle around the point at which center line *b* intersects the scribing line "S'. The laser beam irradiation and transportation means 2 and 6 will be ordered to repeat the unit operation under such a condition.

In the right-hand one of examples shown in Fig. 5, the inner (left-hand) sector of each longitudinal center line *b* crossing the scribing line 'S' near the right-hand edge *hr* is retracted back while the unit operation is repeated in the direction indicated at the arrow. Similarly, the inner (right-hand) sector of each longitudinal center line *b* crossing the other scribing line 'S' near the left-hand edge *hl* is retracted back.

The unit cracks *n* produced in this manner will continue one from another to form a 'straight' perpendicular crack 'E' following and coincident with the scribing line 'S',

A 'curved' perpendicular crack may alternatively be produced using in a modified manner the present method and apparatus.

Fig. 6 illustrates an example of operation for forming such a curved but perpendicular crack.

The apparatus 1 as fully discussed above may be employed to produce the curved perpendicular crack. In this case, its controller 7 will work to produce such cracks along a predetermined curved scribing line 'S' whose tangents change their direction from point to point. For this purpose, each of the successive longitudinal center lines *b* of heated spots 10 is designed to intersect at a right angle the corresponding point of line 'S' as shown in Fig. 6. The controller 7 will command the irradiation, ejection and transportation means 2, 3 and 6 to repeat the unit operation in this manner.

Selected here to perform the unit operation taking into account the varying radius of curvature may be one or more of the 'N' units 51 each comprising one laser beam irradiation means 2 and one cooling medium ejection means 3. Different one or ones may be selected from the 'N' units 51 for different areas to be processed by the unit operations.

The unit cracks *n* thus produced will successively adjoin one another to provide a continuous curved crack 'U'.

In summary, the present invention provides herein a method of and an apparatus for forming any desired perpendicular crack in a brittle substrate that may be a semiconductor wafer, a glass plate, a ceramics plate or the like. In any case, the perpendicular crack thus produced should enable one portion of the brittle substrate to be cut and severed from the others along.

## Claims

1. A method of forming a perpendicular crack in a brittle substrate, the method comprising the steps of:
irradiating a laser beam onto the brittle substrate along a predetermined scribing line so as to cause the laser beam to produce at least one heated spot, and
subsequently ejecting a cooling medium to impinge on the heated spot so as to form a cooled spot,
wherein the preceding step of forming the heated spot and the succeeding step of forming the cooled spot after interrupting the irradiation of a laser beam onto the heated spot are combined with each other to constitute a unit operation, so that the cooled spot superimposed on the previously heated spot is effective to restore thermal equilibrium in and around the spots.

2. The method as defined in claim 1, wherein the heated spot has a longitudinal center line intersecting the predetermined scribing line generally at an angle of 90 degrees.

3. The method as defined in claim 1, wherein the unit operation is conducted at least one time so that the perpendicular crack of a unit length along the scribing line will penetrate the brittle substrate in a direction of its thickness and at one area of said brittle substrate, and thereafter the unit operation is repeated at least one more time at another area of said brittle substrate and changing the location where heated spots are to be formed, so that a further perpendicular crack thus formed and also having the unit length does continue from the first mentioned crack along the scribing line.

4. The method as defined in claim 1, 2 or 3, wherein the unit operation for forming the perpendicular crack is repeated a few or several times without changing the position of heated and cooled spots at a start point of the predetermined scribing line, with the start point being located near any side edge of the brittle substrate.

5. The method as defined in claim 1, wherein each of the cooled spots covers and cools an area larger than the corresponding heated spot previously formed, mainly due to heat of vaporization of the cooling medium.

6. The method as defined in claim 1, wherein each cooled spot is formed by an ink jet type ejection of the cooling liquid medium.

7. The method as defined in claim 1, wherein parameters for designing the heated spots are radiation energy and duration of laser beams, shape and/or intervals of heated spots.

8. The method as defined in claim 3, wherein 'D' as a distance between the two adjacent perpendicular unit cracks is given in relation to a unit length `L' of each crack produced by one unit operation in the direction of scribing line, using an inequality: L/2 < D < L.

9. The method as defined in claim 2, wherein an angle at which the longitudinal center line of each heated spot does intersect the predetermined scribing line in a region near or close to any end of the substrate is capable of being changed.

10. The method as defined in claim 1 or 2, wherein if the predetermined scribing line is located near any side edge of the brittle substrate, then the longitudinal center line of each heated spot is swung an angle about a point where this center line intersects the scribing line when repeating the unit operations, so that an inner sector of the center line is retracted in a direction opposite to the advancing direction of unit operations, whereby the perpendicular crack tending to become curved near the side edge of the brittle substrate can be made straight in alignment with the predetermined scribing line.

11. The method as defined in claim 1, wherein the unit operation is composed of the preceding step of simultaneously forming a number 'N' of heated spots and the succeeding step of simultaneously forming the same number 'N' of cooled spots after interrupting the irradiation of laser beam onto the heated spots, so that the unit operation is conducted at least one time in order that a series of perpendicular cracks each of a unit length are formed at once in such a manner that this series of cracks have an increased length that corresponds to the unit length multiplied by 'N' along the scribing line, with each perpendicular crack included in such a series penetrating the brittle substrate in a direction of its thickness and at one area of said brittle substrate, and wherein the unit operation is repeated at least one more time at another area of said brittle substrate and changing the location where heated spots are to be formed this time such that a further series of perpendicular cracks are formed to likewise have the in-creased length may smoothly continue from the first mentioned series of cracks along the scribing line.

12. The method as defined in claim 1 or 2, wherein an inequality: 0 < *a* < 4*t* in which *a* denotes the major axis of each heated spot on the brittle substrate, with t indicating the thickness thereof, is applied to the step of forming the heated spots.

13. The method as defined in claim 1 or 2, wherein an inequality: 0 < C < *a*/2 in which *a* denotes the major axis of each heated spot on the brittle substrate, with 'C' indicating a diameter of each cooled spot regarded as a circle, is applied to the step of forming the cooled spots by ejection of the cooling medium.

14. An apparatus for forming a perpendicular crack in a brittle substrate comprising:
an irradiation means for irradiating a laser beam onto the brittle substrate so as to provide a heated spot thereon,
a transportation means for moving the laser beam relative to the brittle substrate and along a scribing line predetermined thereon,
an ejection means for ejecting a cooling medium onto a brittle substrate portion where the heated spot has been formed, with this portion then forming a cooled spot, and
a controller for controlling the irradiation, transportation and ejection means,
wherein the irradiation means is constructed such that the heated spot has a longitudinal center line intersecting the predetermined scribing line substantially at an angle of 90 degrees,
and wherein the controller is constructed such that the preceding step of forming the heated spot and the succeeding step of forming the cooled spot after interruption of the irradiation of laser beam onto the heated spot are combined with each other to constitute a unit operation, so that the unit operation is to be conducted at least one time so that the perpendicular crack of a unit length along the scribing line will penetrate the brittle substrate in a direction of its thickness and at one area of said brittle substrate, and that the controller will then give command signals to the irradiation, transportation and ejection means so as to repeat at least one time the unit operation at another area of said brittle substrate, whereby a further perpendicular crack thus formed and also having the unit length has to continue from the first mentioned crack along the scribing line, with the cooled spot superimposed on the previously heated spot having to be effective to restore thermal equilibrium in and around the spots.

15. An apparatus as defined in claim 14, wherein the controller is constructed to give command signals to all the relevant means to repeat several times the unit operation for forming the perpendicular crack, without changing the position of heated and cooled spots at a start point of the predetermined scribing line.

16. An apparatus as defined in claim 14, wherein the ejection means is constructed to eject the cooling liquid medium by an ink jet type ejection system.

17. An apparatus as defined in claim 14, wherein the ejection means is accompanied by a supplementary cooling means so that after the jetted coolant has formed each cooled spot, the cooling means will cover and cool an area larger than the heated spot.

18. An apparatus as defined in claim 14, wherein the controller is constructed to give command signals to each relevant means to form the heated spots taking into account the parameters such as radiation energy and duration of laser beams, shape and/or intervals of those spots.

19. An apparatus as defined in claim 14, wherein the controller is constructed to give further command signals to the transportation means so that unit length 'L' of each crack and a distance 'D' between the two adjacent perpendicular unit cracks do satisfy an inequality: L/2 < D < L.

20. An apparatus as defined in claim 14, wherein the controller is constructed to give command signals to the irradiation means to change an angle at which the major axis of each heated spot intersects the predetermined scribing line.

21. An apparatus as defined in claim 14, wherein the controller is constructed to give command signals to all the relevant means such that if the predetermined scribing line is located near any side edge of the brittle substrate, then the longitudinal center line of each heated spot is swung an angle about a point where this center line intersects the scribing line when repeating the unit operations, so that an inner sector of the center line is retracted in a direction opposite to the advancing direction of unit operations, whereby the perpendicular crack tending to become curved near the side edge of the brittle substrate can be made straight in alignment with the predetermined scribing line.

22. An apparatus as defined in claim 14, wherein the controller is constructed to give command signals to all the relevant means such that the unit operation is composed of the preceding step of simultaneously forming a number 'N' of heated spots and the succeeding step of simultaneously forming the same number 'N' of cooled spots after interrupting the irradiation of laser beam onto the heated spots, so that the unit operation is conducted at least one time in order that a series of perpendicular cracks each of a unit length are formed at once in such a manner that this series of cracks have an increased length that corresponds to the unit length multiplied by 'N' along the scribing line, with each perpendicular crack included in such a series penetrating the brittle substrate in a direction of its thickness and at one area of the brittle substrate, and wherein the unit operation is repeated at least one more time at another area of said brittle substrate and changing the location where heated spots are to be formed this time such that a further series of perpendicular cracks are formed to likewise have the increased length may smoothly continue from the first mentioned series of perpendicular cracks along the scribing line.

23. An apparatus as defined in claim 14, wherein the controller orders the irradiation means to operate satisfying another inequality: 0 < *a* < 4*t* in which *a* denotes the major axis of each heated spot on the brittle substrate, with *t* indicating the thickness thereof.

24. An apparatus as defined in claim 14, wherein the controller orders the ejection means to perform under the condition that is defined with still another inequality: 0 < C < *a*/2 in which *a* denotes the major axis of each heated spot on the brittle substrate, with 'C' indicating a diameter of each cooled spot regarded as a circle.
